# EUROPÄISCHE PATENTSCHRIFT

(11) **EP 0 514 839 B1**
(45) Veröffentlichungstag und Bekanntmachung des Hinweises auf die Patenterteilung: **09.12.1998**
(21) Anmeldenummer: 92108440.6
(22) Anmeldetag: 19.05.1992
(51) Int. Cl.: G01R 27/26

(54) **Messschaltung zur Messung einer Kapazität**
Circuit for measuring capacity
Circuit pour mesurer la capacité

(30) Priorität: 24.05.1991 DE 4116961
(43) Veröffentlichungstag der Anmeldung: 25.11.1992
(73) Patentinhaber: Gossen- Metrawatt GmbH, D-8500 Nürnberg (DE)
(72) Erfinder: Kindermann, Robert, W-8500 Nürnberg 90 (DE); Styhler, Klaus, W-8500 Nürnberg 50 (DE); Ziegler, Herbert, W-8500 Nürnberg 30 (DE)
(74) Vertreter: Hafner, Dieter, Dr.rer.nat., Dipl.-Phys.

(56) Entgegenhaltungen:
- DD-A- 137 490
- DE-A- 2 426 859
- DE-A- 2 836 324
- DE-A- 3 744 524

## Beschreibung

Die Erfindung betrifft eine Meßschaltung zur Messung einer Kapazität nach dem Oberbegriff des Anspruchs 1.

Für preisgünstige Multimeter benötigt man eine möglichst einfache Meßschaltung zur Kapazitätsmessung. Eine aus DIN 41 328, Blatt 4, Juni 1974 bekannte, nach dem Entladeprinzip arbeitende Schaltungsanordnung hat sich unter anderem auch wegen ihrer guten Meßgenauigkeit sehr bewährt. Hierbei wird die zu messende Kapazität Cx auf eine zuvor festgelegte Referenzspannung aufgeladen und danach über einen Entladewiderstand RE entladen, wobei die Zeit vom Beginn der Entladung bis zum Abfall der Spannung an der Kapazität Cx auf einen bestimmten Wert gemessen wird. Die Entladung erfolgt mit der Zeitkonstante τ = RE · Cx und die Kapazität Cx = k · t ist der gemessenen Entladezeit t entsprechend der Konstante k proportional. Die Messung der Entladezeit t erfolgt in der Regel mit Hilfe eines Zählers, der während der Entladung so lange Taktimpulse zählt, bis ein Komparator signalisiert, daß die Spannung an der Kapazität die vorgegebene Entladespannung erreicht hat.

Für das Umschalten zwischen Lade- und Entladephase verwendet man bevorzugt Schalter mit kleinem Durchgangswiderstand, damit der Ladewiderstand für die Kapazität und damit auch die Ladezeitkonstante möglichst klein bleiben. Eine Schaltungsanordnung, die mit einem elektronischen Schalter arbeitet, ist aus der DE-A-28 36 324 bekannt. Durch das Einfügen des Schalters in den Gegenkopplungskreis eines Operationsverstärkers wird erreicht, daß der Durchgangswiderstand des Schalters nicht in die Messung eingeht und somit auch nicht die Lade- oder Entladezeitkonstante erhöht. Bei niedrigem Ladewiderstand kann mit einer fest vorgegebenen Ladezeit gearbeitet werden, weil selbst bei großen Kapazitäten die Ladezeitkonstante so klein bleibt, daß immer eine ausreichende Aufladung erzielt wird.

Von besonderer Bedeutung für den Gebrauchswert eines Multimeters ist dessen Sicherung gegen Fremdspannungen, die über das Meßobjekt eingeschleift werden können oder auch bei fehlerhaftem Anschluß an ein falsches Meßobjekt am Meßeingang entstehen. Es muß deshalb dafür gesorgt werden, daß auftretende Fremdspannungen nicht zu einer Zerstörung von Bauteilen des Meßkreises führen, die einen Ausfall des Multimeters bewirken oder sogar den Bedienenden gefährden können.

Es ist bekannt, den Eingang von Meßgeräten durch einen Kaltleiter in Verbindung mit Schwellwertelementen, vorzugsweise zwei Dioden, zu schützen. Die Schwellwertelemente sorgen dafür, daß Überspannungen entsprechend ihrer Polarität nahezu kurzgeschlossen werden und der hierbei auftretende erhöhte Strom über den Kaltleiter zu dessen Erwärmung und einer daraus resultierenden Strombegrenzung führt. Zur Messung von Kapazitäten hat man derartige Schutzschaltungen jedoch nicht eingesetzt, weil der relativ hohe Widerstand eines Kaltleiters alle Anstrengungen zur Erreichung eines kleinen Ladewiderstandes und damit einer kleinen Ladezeitkonstante zunichte machen würde. Die anstelle des Kaltleiters verwendeten Schmelzsicherungen haben jedoch den Nachteil, daß sie nach einem Durchbrennen ausgetauscht werden müssen.

Aufgabe der Erfindung ist es, ausgehend von der DE-A-2 836 324 eine Meßschaltung der im Oberbegriff des Anspruchs 1 genannten Art zu schaffen, die sich besonders für preisgünstige Multimeter eignet, gegen Fremdspannungen schützende Bauteile enthält, die im Fehlerfall nicht zerstört werden und somit auch nicht ausgetauscht werden müssen und bei der mit einer festen Ladezeit gearbeitet werden kann, ohne daß es bei großen Kapazitäten zu Meßfehlern kommt.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Die erfindungsgemäße Lösung besteht zunächst in einer radikalen Abkehr von dem Ziel, eine möglichst kleine Ladezeitkonstante durch möglichst kleine ohmsche Widerstände im Ladekreis zu erreichen. Dies ermöglicht nicht nur die Verwendung eines Kaltleiters zum Schutz vor Fehlerspannungen, sondern befreit auch von dem Zwang besondere Maßnahmen zu treffen, um den im Vergleich zu mechanischen Schaltern relativ hohen Durchgangswiderstand von elektronischen Schaltern zu reduzieren. Schränkt man den zulässigen Kapazitätsmeßbereich auf entsprechende Höchstwerte ein, was besonders bei preisgünstigen Multimetern akzeptabel erscheint, so kann mit einer festen Ladezeit gearbeitet werden, die noch innerhalb einer für derartige Messungen üblichen Meßzeit, z. B. bei maximal einer Sekunde liegt.

Entscheidend ist, daß es bei Kapazitäten, die den zulässigen Meßbereich überschreiten, nicht zu irreführenden Fehlmessungen kommt. Ohne geeignete Zusatzmaßnahmen wäre das jedoch unvermeidlich, denn eine zu große Kapazität würde innerhalb der fest vorgegebenen Ladezeit nicht auf den vorgegebenen Endwert der Ladespannung aufgeladen. Bei einer sich an die Ladezeit automatisch anschließenden Entladung der Kapazität würde der ebenfalls vorgegebene Wert der Entladespannung schneller erreicht, weil die Entladung von einer niedrigeren Spannung aus erfolgte. Die kürzere Entladezeit würde somit eine wesentlich kleinere Kapazität vortäuschen. Erfindungsgemäß sind deshalb Überwachungsmittel vorgesehen, die die jeweilige an der zu messenden Kapazität entstehende Ladespannung dahingehend überwachen, ob sie den vorgegebenen Endwert erreicht, wobei dieser Endwert entsprechend der angestrebten Meßgenauigkeit geringfügig unter dem Spannungswert der Konstantspannungsqelle liegt. Die Überwachungsmittel wirken hierbei so auf die Ablaufsteuerung bzw. auf die Meßwertverarbeitung, daß Fehlanzeigen unterbleiben und Kapazitätsüberschreitungen erkennbar sind.

Eine besonders vorteilhafte weiterbildung des Erfindungsgegenstandes sieht vor, daß als Überwachungsmittel vorzugsweise derselbe Komparator dient, der ohnehin bereits benötigt wird, um bei der Entladung das Erreichen der vorgegebenen Entladespannung zu überwachen. Der nach abgeschlossener Entladephase einen bestimmten Signalzustand annehmende Komparator wird nur dann in seinen zweiten Signalzustand zurückgestellt, wenn die an seinem Eingang anliegende Spannung während der Ladephase einen als Referenzspannung vorgegebenen Mindestwert überschreitet. Im einfachsten Fall kann dieser Mindestwert gleich der vorgegebenen Entladespannung sein. Wird der Mindestwert während der Ladezeit der Kapazität nicht erreicht, so kann die Ablaufsteuerung das Fehlen der Rückstellung des Komparators als eine zu große Kapazität interpretieren und ein geeignetes Signal, ggf. eine Überlauf anzeige, auslösen.

Bei der maximal zulässigen Kapazität erreicht die Ladespannung während der festen Ladezeit genau den vorgegebenen Endwert. Es wäre deshalb zweckmäßig, diesen Endwert einem zweiten Komparator als Referenzwert vorzugeben, um ein Überschreiten des zulässigen Kapazitätsbereiches zu überwachen. In diesem Fall könnte die Ablaufsteuerung das Fehlen einer Signaländerung am Komparator als unzulässig große Kapazität interpretieren.

Eine Alternative hierzu, die wiederum mit nur einem Komparator auskommt, sieht vor, daß dessen Referenzspannung entsprechend der Lade- oder Entladephase umschaltbar ist, so daß während der Ladephase eine dem Endwert entsprechende Ladespannung und während der Entladephase ein der Entladespannung entsprechender Spannungswert überwacht wird. Auch hier kann die Ablaufsteuerung aus der Art des Komparatorsignals schließen, ob die gemessene Kapazität den zulässigen Bereich überschreitet.

Eine gegenüber der Meßschaltung nach der DE-A-28 36 324 wesentlich preisgünstigerer Schaltungsaufbau ist in einer Weiterbildung des Erfindungsgegenstandes dadurch erreichbar, daß der zum Umschalten zwischen Lade- und Entladephase benötigte Halbleiterschalter nicht im Gegenkopplungskreis eines Operationsverstärkers liegt, sondern wegen seines gegenüber dem Kaltleiter vernachlässigbaren Übergangswiderstandes unmittelbar in den Lade-/Entladekreis zwischen der zu messenden Kapazität bzw dem vorgeschalteten Kaltleiter und der Konstantspannungsquelle eingefügt ist. Soweit bei diesem Schaltungsaufbau überhaupt ein Operationsverstärker benötigt wird, kann ein preisgünstiger Typ verwendet werden, an den keine so hohen Anforderungen bezüglich seiner Anstiegsgeschwindigkeit gestellt werden müssen wie bei bekannten Schaltungen und der dementsprechend auch mit einem niedrigeren Versorgungsstrom auskommt.

Bei einem sich über mehrere Teilbereiche erstreckenden besonders großen Kapzitätsmeßbereich ist es zweckmäßig den Entladewiderstand so anzupassen, daß die erzeugten Entladezeiten nicht allzu extrem auseinander liegen. Es ist deshalb ein zweiter steuerbarer Halbleiterschalter vorgesehen, der durch Umschalten eine Widerstandsänderung ermöglicht. Während relativ hochohmige Entladewiderstände auch während der Ladephase angeschlossen bleiben, da sie nur einen vernachlässigbaren Strom ziehen, ist es vorteilhaft, entsprechend niederohmige Entladewiderstände während der Ladephase vom Ladekreis zu trennen und den zugehörigen zweiten Halbleiterschalter im Wechsel mit dem ersten Halbleiterschalter zu schalten.

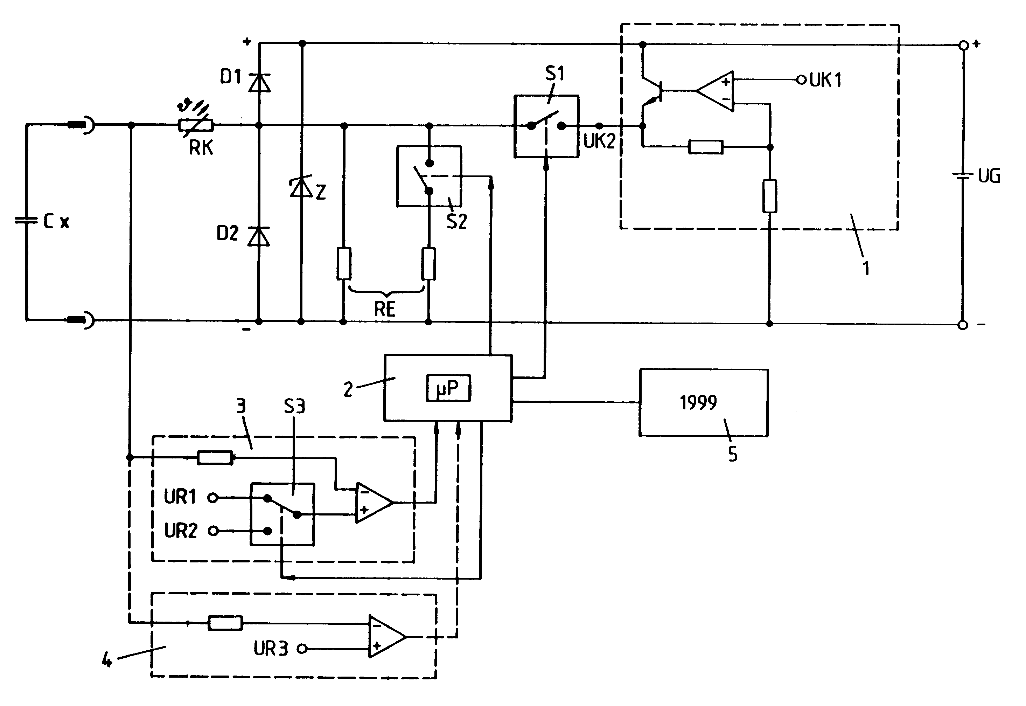

Ein Ausführungsbeispiel der Erfindung ist in der Zeichnung dargestellt und wird im folgenden näher beschrieben.

Eine zu messende unbekannte Kapazität Cx liegt am Eingang einer Meßschaltung und wird während der Ladephase durch eine Konstantspannungsquelle 1 auf einen vorgegebenen Endwert der Ladespannnung aufgeladen. Bekanntlich nähert sich die Ladespannung einer über einen Widerstand aufgeladenen Kapazität asymptotisch dem Wert der von der Konstantspannungsquelle 1 abgegebenen Spannung UK2. Der Endwert der Ladespannung wird deshalb so festgelegt, daß er entsprechend der zulässigen Meßtoleranz nur geringfügig unterhalb der zur Ladung dienenden Konstantspannung UK2 liegt.

Ausgehend von der Konstantspannungsquelle 1 fließt der Ladestrom über einen ersten Schalter S1, dessen Schaltzustand durch eine Ablaufsteuerung 2 bestimmt wird und der während der Ladephase geschlossen ist. Zwischen den ersten Schalter S1 und die Kapazität Cx ist ein Kaltleiter RK in den Ladestromkreis eingefügt, der in Verbindung mit zwei als Dioden ausgeführten Schwellwertelementen Dl, D2 die Meßschaltung vor sie gefährdenden Fremdspannungen schützt. Gelangt eine zu hohe Fremdspannung an den Eingang der Meßschaltung, so wird diese entsprechend ihrer Polarität über eines der Schwellwertelemente D1, D2 quasi kurzgeschlossen. Da der Kurzschlußstrom positiver Fremdspannungen über eine zur Stromversorgung der Konstantspannungsquelle 1 dienende Gleichspannungsquelle UG fließt, ist zum Schutz noch eine Zenerdiode parallel geschaltet, die den vom Kurzschlußstrom an der Gleichspannungsquelle UG erzeugten Spannungsabfall begrenzt.

Die Ladung der Kapazität Cx erfolgt während einer fest vorgegebenen Ladezeit, die so bemessen ist, daß alle innerhalb des zulässigen Meßbereiches liegenden Kapazitäten mindestens auf die vorgegebene Ladespannung aufgeladen werden. Im Anschluß an die Ladezeit öffnet die Ablaufsteuerung 2 den ersten Schalter S1 und leitet damit die Entladephase ein. Die Entladung der Kapazität Cx erfolgt über einen Entladewiderstand RE. Dieser kann entsprechend dem jeweils gewählten Teilmeßbereich, zur besseren Anpassung der Entladezeit, mit Hilfe eines zweiten Schalters S2 bei Bedarf umgeschaltet werden. Sofern der Entladewiderstand RE hierdurch einen relativ niederohmigen Wert erreicht, so daß während der Ladung ein nennenswerter Leckstrom entstehen würde, muß die Ablaufsteuerung dafür sorgen, daß der zweite Schalter S2 im Gegentakt mit dem ersten Schalter S1 gesteuert wird, also solange geöffnet bleibt, wie der erste Schalter S1 geschlossen ist.

Die Entladung der Kapazität Cx erfolgt solange, bis eine vorgegebene, deutlich unter der Ladespannung liegende, aber von Null verschiedene Entladespannung erreicht ist. Deren Spannungswert entspricht einer an einem ersten Komparator 3 anliegenden Referenzspannung UR1, so daß der Komparator ein entsprechendes Ausgangssignal abgibt, sobald die Entladespannung die erste Referenzspannung UR1 unterschreitet.

Nach Abschluß der Entladephase wird die Kapazität Cx erneut geladen. Falls jedoch ihr Wert den zulässigen Kapazitätsmeßbereich überschreitet, lädt sich die Kapazität Cx aufgrund der durch den Kaltleiter RK bewirkten großen Ladezeitkonstante, innerhalb der festen Ladezeit nicht auf die vorgegebene Ladespannung auf. Bleibt aber die Ladespannung unterhalb der ersten Referenzspannung UR1, so kann der erste Komparator 3 nicht in den für die Entladung benötigten Ausgangszustand zurückkehren. Der Ablaufsteuerung wird dadurch schon zu Beginn der Entladung vorgetäuscht, daß die vorgegebene Entladespannung quasi in der Zeit Null erreicht wurde, es sich somit um eine extrem kleine Kapazität handelt. Um eine daraus resultierende Fehlanzeige zu vermeiden, ist die Ablaufsteuerung so programmiert, daß sie den ersten Komparator 3 dahingehend überwacht, ob sein Ausgangssignal während der Ladephase einen Signalwechsel erfährt. Sollte das nicht der Fall sein, wird mit Hilfe einer Anzeigeeinheit ein Überlaufsignal erzeugt, das erkennbar macht, daß die zu messende Kapazität den zulässigen Bereich überschreitet.

Ist die zu messende Kapazität gerade so groß, daß ihre Ladespannung in den Bereich zwischen der ersten Referenzspannung UR1 und der vorgegebenen Ladespannung fällt, so wird zunächst eine sehr kleine Kapazität vorgetäuscht. Da jedoch in jedem Meßzyklus das Laden der Kapazität bei einem Spannungsniveau beginnt, das durch die jeweilige Entladespannung bestimmt wird, erreicht die Ladespannung in einem der folgenden Meßzyklen den vorgegebenen Endwert der Ladespannung, so daß der angezeigte Meßwert ebenfalls sehr rasch den Überlauf erreicht.

Als Alternative zu dem gleitenden Überlauf, wie er bei bestimmten Kapazitäten auftritt, wenn zu große Kapazitäten allein durch den mit nur einer ersten Referenzspannung UR1 beaufschlagten, ersten Komparator 3 erfaßt werden sollen, kann man auch mit einer zweiten Referenzspannung UR2 arbeiten. Mit Hilfe der Ablaufsteuerung müßte ein dritter Schalter S3 jeweils so gesteuert werden, daß während der Ladephase eine zweite Referenzspannung UR2 und während der Entladephase die erste Referenzspannung UR1 eingeschaltet wird. Die zweite Referenzspannung UR2 müßte in diesem Fall der vorgegebenen Ladespannung entsprechen. Letztlich erfolgt auch hier die Signalisierung eines Überlaufs in der zuvor beschriebenen Weise.

Schließlich ergibt sich als weitere Alternative die Möglichkeit, anstelle der zweiten Referenzspannung UR2 einen zweiten Komparator 4 mit einer dritten Referenzspannung UR3 zu verwenden. Die der vorgegebenen Ladespannung entsprechende dritte Referenzspannung UR3 muß während der Ladephase von der Ladespannung erreicht werden, damit die Ablaufsteuerung 2 bzw. eine zugehörige Meßwertverarbeitungsschaltung kein Überlaufsignal erzeugt.

Die den beiden Komparatoren 3, 4 eingangsseitig vorgeschalteten Widerstände haben die Aufgabe den Eingangsstrom zu begrenzen. Ein zur Konstantspannungsquelle 1 gehöriger Operationsverstärker ist mit einem nachgeschalteten Transistor und zwei Widerständen als Spannungsverstärker geschaltet, der eine ihm eingangsseitig zugeführte erste Konstantspannung UK1 zur zweiten Konstantspannung UK2 verstärkt.

## Patentansprüche

1. Meßschaltung zur Messung einer Kapazität (Cx) nach der Entlademethode, mit einer Konstantspannungsquelle (1) zum Aufladen der Kapazität (Cx), einem Entladewiderstand (RE) mit bekanntem Widerstandswert, über den eine Entladung der Kapazität (Cx) erfolgt und einer Ablaufsteuerung (2), die durch Steuerung mindestens eines entsprechend angeordneten Schalters (S1) die Lade- und Entladephase bestimmt, sowie mit einem, vorzugsweise der Ablaufsteuerung (2) zugeordneten Zähler (5), der während der Entladung solange Taktimpulse zählt, bis ein Komparator (3) signalisiert, daß die Entladespannung an der Kapazität (Cx) eine vorgegebene erste Referenzspannung (UR1) unterschritten hat und damit die Entladezeit beendet ist, dadurch gekennzeichnet, daß zum Schutz gegen Fehlerspannungen am Eingang der Meßschaltung in Reihe zur Kapazität (Cx) ein vom Ladestrom und Entladestrom durchflossener Kaltleiter (RK) liegt, durch den sich die Ladezeit der Kapazität (Cx) erhöht, wobei die Ladezeit der Kapazität (Cx) durch eine Beschränkung des zulässigen Kapazitäts bereiches auf einen Höchstwert im Rahmen üblicher Meßzeiten bleibt, und daß Überwachungsmittel (3, 4) vorgesehen sind, die so auf die Ablaufsteuerung (2) und/oder eine zugehörige Meßwertverarbeitung einwirken, daß erkennbar wird und Fehlanzeigen unterbleiben, wenn innerhalb der fest vorgegebenen Ladezeit die Ladespannung einen vorgegebenen Spannungswert nicht erreicht, weil die Kapazität (Cx) den Höchstwert des zulässigen Kapazitätsbereiches überschreitet.

2. Meßschaltung nach Anspruch 1, dadurch gekennzeichnet, daß als Überwachungsmittel mindestens ein Komparator (3, 4) dient, der das Erreichen eines vorgegebenen Mindestwertes der Ladespannung an der Kapazität (Cx) erfaßt und ein entsprechendes Ausgangssignal der Ablaufsteuerung (2) zuführt, die ihrerseits so programmiert ist, daß sie am Ausgangssignal des entsprechenden Komparators (3,4) erkennt, ob während der Ladezeit der vorgegebene Mindestwert der Ladespannung erreicht und überschritten wurde.

3. Meßschaltung nach Anspruch 2, dadurch gekennzeichnet, daß als Überwachungsmittel derselbe Komparator (3) dient, der das Erreichen und Unterschreiten der vorgegebenen Entladespannung mit Hilfe einer ersten Referenzspannung (UR1) überwacht, wobei dieser während der Ladung der Kapazität (Cx) das Erreichen einer der ersten Referenzspannung (UR1) entsprechenden Ladespannung erfaßt und ein entsprechendes Signal der Ablaufsteuerung (2) zuführt.

4. Meßschaltung nach Anspruch 2, dadurch gekennzeichnet, daß als Überwachungsmittel derselbe Komparator (3) dient, der das Erreichen und Unterschreiten der vorgegebenen Entladespannung mit Hilfe einer ersten Referenzspannung (UR1) überwacht, und daß zwischen dieser und einer zweiten Referenzspannung (UR2), die der vorgegebenen Ladespannung entspricht, so umgeschaltet wird, daß der Komparator (3) während der Ladung der Kapazität (Cx) das Erreichen einer der zweiten Referenzspannung (UR2) entsprechenden Ladespannung erfaßt und ein entsprechendes Signal der Ablaufsteuerung (2) zuführt.

5. Meßschaltung nach Anspruch 2, dadurch gekennzeichnet, daß ein zweiter Komparator (4) vorgesehen ist und dieser mit einem Eingang an einer dritten Referenzspannung (UR3) liegt, die der vorgegebenen Ladespannung entspricht, und daß der zweite Komparator (3) während der Ladung der Kapazität (Cx) das Erreichen einer der zweiten Referenzspannung (UR2) entsprechenden Ladespannung erfaßt und ein entsprechendes Signal der Ablaufsteuerung (2) zuführt.

6. Meßschaltung nach einem der vorhergehenden Ansprüche, dadurch gekennzeichnet, daß der steuerbare erste Schalter (S1) vorzugsweise ein Halbleiterschalter ist und zwischen der Konstantspannungsquelle (1) und dem Kaltleiter (RK) angeordnet ist, und beim Öffnen des ersten Schalters (S1) die Aufladung unterbrochen wird und eine Entladung über den Entladewiderstand (RE) beginnt.

7. Meßschaltung nach einem der vorhergehenden Ansprüche, dadurch gekennzeichnet, daß ein steuerbarer zweiter Schalter (S2) vorgesehen ist, der durch Umschalten eine Widerstandsänderung des Entladewiderstandes (RE) ermöglicht und diese vorzugsweise zur Reduzierung des Widerstandswertes vorgesehene Umschaltung des zweiten Schalters (S2) bei entsprechend kleinen Widerstandswerten des Entladewiderstandes (RE) im Wechsel mit dem ersten Schalter (S1) erfolgt.

8. Meßschaltung nach einem der vorhergehenden Ansprüche, dadurch gekennzeichnet, daß ausgehend vom Eingang der Meßschaltung hinter dem Kaltleiter (RK) zwei Schwellwertelemente (D1,D2), vorzugsweise Dioden, so angeordnet sind, daß Fremdspannungen einer Polarität unmittelbar zum zweiten Pol des Eingangs der Meßschaltung und Fremdspannungen der anderen Polarität über eine zur Versorgung der Konstantspannungsquelle (1) dienende Gleichspannungsquelle (UG) zum zweiten Pol des Meßschaltungseingangs abgeleitet sind.

9. Meßschaltung nach Anspruch 8, dadurch gekennzeichnet, daß parallel zur Gleichspanungsquelle (UG) eine Zenerdiode (Z) angeordnet ist.

## Claims

1. Measuring circuit for measuring a capacitance (Cx) according to the discharge method, having a constant-voltage source (1) for charging the capacitance (Cx), a discharge resistor (RE) which has a known resistance value and via which the capacitance (Cx) is discharged, and also having a sequence control system (2), which determines the charge and discharge phase by controlling at least one appropriately arranged switch (S1), and having a counter (5) which is preferably associated with the sequence control system (2) and continues to count clock pulses during discharge until a comparator (3) signals that the discharge voltage at the capacitance (Cx) has fallen below a preset, first reference voltage (UR1) and, consequently, the discharge time has come to an end, characterised in that, to protect against fault voltages, a PTC thermistor (RK), through which the charge current and discharge current flow and owing to which the charge time of the capacitance (Cx) increases, is situated at the input of the measuring circuit in series with the capacitance (Cx), the charge time of the capacitance (Cx) remaining within the scope of conventional measurement times by limiting the permissible capacitance range to a maximum value, and in that monitoring means (3, 4) are provided and act upon the sequence control system (2) and/or an associated measurement value processor in such a manner that it is possible to recognise, and incorrect displays do not occur, when the charge voltage does not reach a preset voltage value within the permanently preset charge time because the capacitance (Cx) exceeds the maximum value of the permissible capacitance range.

2. Measuring circuit according to claim 1, characterised in that at least one comparator (3, 4) is used as the monitoring means and detects when a preset minimum value for the charge voltage at the capacitance (Cx) is reached and supplies a corresponding output signal to the sequence control system (2) which, for its part, is programmed to recognise from the output signal of the corresponding comparator (3, 4) whether the preset minimum value for the charge voltage has been reached and exceeded during the charge time.

3. Measuring circuit according to claim 2, characterised in that the same comparator (3) is used as the monitoring means as is used to monitor, with the aid of a first reference voltage (UR1), when the voltage has reached and fallen below the preset discharge voltage, the comparator detecting, during the charging of the capacitance (Cx), when a charge voltage corresponding to the first reference voltage (UR1) has been reached and supplying a corresponding signal to the sequence control system (2).

4. Measuring circuit according to claim 2, characterised in that the same comparator (3) is used as the monitoring means as is used to monitor, with the aid of a first reference voltage (UR1), when the voltage has reached and fallen below the preset discharge voltage, and in that switching takes place between the first reference voltage (UR1) and a second reference voltage (UR2), which corresponds to the preset charge voltage, in such a manner that the comparator (3) detects, during the charging of the capacitance (Cx), when a charge voltage corresponding to the second reference voltage (UR2) has been reached and supplies a corresponding signal to the sequence control system (2).

5. Measuring circuit according to claim 2, characterised in that a second comparator (4) is provided and has an input at a third reference voltage (UR3) which corresponds to the preset charge voltage, and in that the second comparator (3) detects, during the charging of the capacitance (Cx), when a charge voltage corresponding to the second reference voltage (UR2) has been reached and supplies a corresponding signal to the sequence control system (2).

6. Measuring circuit according to any one of the preceding claims, characterised in that the controllable first switch (S1) is preferably a semi-conductor switch and is arranged between the constant-voltage source (1) and the PTC thermistor (RK), and, when the first switch (S1) is opened, the charging process is interrupted and a discharging process begins via the discharge resistor (RE).

7. Measuring circuit according to any one of the preceding claims, characterised in that a controllable second switch (S2) is provided and enables the resistance of the discharge resistor (RE) to be changed by switching over, and that switching over, preferably provided to reduce the resistance value, of the second switch (S2) is effected in alternation with the first switch (S1) when resistance values of the discharge resistor (RE) are correspondingly small.

8. Measuring circuit according to any one of the preceding claims, characterised in that, starting from the input of the measuring circuit, two logic threshold elements (D1, D2), preferably diodes, are arranged after the PTC thermistor (RK) so that interference voltages of a first polarity are diverted directly to the second pole of the input of the measuring circuit and interference voltages of the second polarity are diverted to the second pole of the measuring circuit input via a direct voltage source (UG) for supplying the constant-voltage source (1).

9. Measuring circuit according to claim 8, characterised in that a Zener diode (Z) is arranged parallel with the direct voltage source (UG).

## Revendications

1. Circuit de mesure servant à mesurer une capacité (Cx) conformément au procédé de décharge, comportant une source de tension constante (1) servant à charger la capacité (Cx), une résistance de décharge (RE) ayant une valeur résistance connue et dans laquelle s'effectue une décharge de la capacité (Cx), et une unité de commande d'exécution (2), qui détermine la phase de charge et la phase de décharge par commande d'au moins un interrupteur (S1) monté de façon correspondante, ainsi qu'un compteur (5) associé de préférence à l'unité de commande d'exécution (2) et qui, pendant la décharge compte des impulsions de cadence jusqu'à ce qu'un comparateur (3) signale que la tension de décharge aux bornes de la capacité (Cx) est tombée au-dessous d'une première tension de référence prédéterminée (UR1) et que par conséquent le temps de décharge est terminé, caractérisé en ce que pour la protection vis-à-vis de tensions d'erreur, à l'entrée du circuit de mesure est branché, en série avec la capacité (Cx), un conducteur froid (RK) parcouru par le courant de charge et le courant de décharge et grâce auquel le temps de chargé de la capacité (Cx) augmente, le temps de charge de la capacité (Cx) restant à une valeur maximale dans le cadre de temps de mesure usuels, en raison d'une limitation de la gamme admissible de capacités, et que sont prévus des moyens de contrôle (3, 4), qui agissent sur l'unité de commande d'exécution (2) et/ou sur un circuit associé de traitement des valeurs de mesure, que des indications erronnées sont identifiées et supprimées lorsque pendant le temps de charge prédéterminé de façon fixe, la tension de charge n'atteint pas une valeur de tension prédéterminée étant donné que la capacité (Cx) dépasse la valeur maximale de la gamme admissible de capacités.

2. Circuit de mesure selon la revendication 1, caractérisé en ce qu'on utilise, comme moyens de contrôle, au moins un comparateur (3, 4), qui détecte le moment où une valeur minimale prédéterminée de la tension de charge aux bornes de la capacité (Cx) est atteinte et envoie un signal de sortie correspondant à l'unité de commande d'exécution (2), qui pour sa part est programmée de telle sorte qu'elle identifie, sur la base du signal de sortie du comparateur correspondant (3, 4), si pendant le temps de charge, la valeur minimale prédéterminée de la tension de charge a été atteinte et dépassée par valeurs supérieures.

3. Circuit de mesure selon la revendication 2, caractérisé en ce qu'on utilise comme moyens de contrôle le comparateur (3) qui contrôle le fait que la tension de décharge est atteinte et dépassée par valeurs inférieures, à l'aide d'une première tension de référence (UR1), ce comparateur détectant, pendant la charge de la capacité (Cx), le fait qu'une tension de charge correspondante à la première tension de référence (UR1) est atteinte, et envoyant un signal correspondant à l'unité de commande d'exécution (2).

4. Circuit de mesure selon la revendication 2, caractérisé en ce qu'on utilise comme moyens de contrôle le comparateur (3), qui contrôle le fait que la tension de décharge prédéterminée est atteinte et dépassée par valeurs inférieures, à l'aide d'une première tension de référence (UR1), et qu'il se produit une commutation entre cette tension de référence et une seconde tension de référence (UR2), qui correspond à la tension de charge prédéterminée, de telle sorte que le comparateur (3) détecte, pendant la charge de la capacité (Cx), le fait qu'une tension de charge correspondant à la seconde tension de référence (UR2) est atteinte, et envoie un signal correspondant à l'unité de commande d'exécution (2).

5. Circuit de mesure selon la revendication 2, caractérisé en ce qu'il est prévu un second comparateur (4) et que ce dernier reçoit à une entrée une troisième tension de référence (UR3), qui correspond à la tension de charge prédéterminée, et que pendant la charge de la capacité (Cx), le second comparateur (3) détecte le fait qu'une tension de charge correspondant à la seconde tension de référence (UR2) est atteinte et envoie un signal correspondant à l'unité de commande d'exécution (2).

6. Circuit de mesure selon l'une des revendications précédentes, caractérisé en ce que l'interrupteur commandable (S1) est de préférence un interrupteur à semiconducteurs et est disposé entre la source de tension constante (1) et le conducteur froid (RK) et que, lors de l'ouverture du premier interrupteur (S1), l'opération de charge est interrompue et une décharge par l'intermédiaire de la capacité de décharge (RE) commence.

7. Circuit de mesure selon l'une des revendications précédentes, caractérisé en ce qu'il est prévu un second interrupteur commandable (S2), qui permet, par commutation, une modification de la résistance de décharge (RE), et que cette commutation du second interrupteur (S1), qui est prévue de préférence pour réduire la valeur résistive, se produit pour de faibles valeurs résistives correspondantes de la résistance de décharge (RE) en alternance avec le premier interrupteur (S1).

8. Circuit de mesure selon l'une des revendications précédentes, caractérisé en ce que deux éléments à valeur de seuil (D1, D2), de préférence des diodes, sont disposés en aval du conducteur froid (RK) à partir de l'entrée du circuit de mesure de telle sorte que des tensions étrangères ayant une polarité sont dérivées directement en direction du second pôle de l'entrée du circuit de mesure et que des tensions étrangères possédant l'autre polarité sont dérivées en direction du second pôle de l'entrée du circuit de mesure par l'intermédiaire d'une source de tension continue (UG) utilisée pour alimenter la source de tension constante (1).

9. Circuit de mesure selon la revendication 8, caractérisé en ce qu'une diode Zener (Z) est disposée en parallèle avec la source de tension continue (UG).
